# DEMANDE DE BREVET EUROPEEN

(11) **EP 4 766 071 A1**
(43) Date de publication de la demande: **24.06.2026**
(21) Numéro de dépôt: 25223566.8
(22) Date de dépôt: 15.12.2025
(51) Int. Cl.: H10B 63/00, H10B 53/30

(54) **DISPOSITIF MÉMOIRE NON-VOLATILE ET PROCÉDÉ DE RÉALISATION**

(30) Priorité: 20.12.2024 FR 2414893
(71) Demandeur: COMMISSARIAT À L'ÉNERGIE ATOMIQUE ET AUX ÉNERGIES ALTERNATIVES, 75015 Paris (FR)
(72) Inventeur: CHÊNE, Thibaut, 38054 GRENOBLE Cedex 09 (FR); NEMOUCHI, Fabrice, 38054 GRENOBLE Cedex 09 (FR); SEGAUD, Roselyne, 38054 GRENOBLE Cedex 09 (FR); BOIXADERAS, Christelle, 38054 GRENOBLE Cedex 09 (FR); CHEVOLLEAU, Thierry, 38054 GRENOBLE Cedex 09 (FR); GRENOUILLET, Laurent, 38054 GRENOBLE Cedex 09 (FR)
(74) Mandataire: Hautier IP

(57) **Abrégé**

L'invention concerne un dispositif mémoire comprenant :
• un transistor (1),
• une interconnexion (I) connectant la source (12), comprenant :
une ligne (212), un via (222), une première portion (32a) d'une couche d'arrêt de gravure (30) intercalée entre le via (222) et la ligne (212),
• un élément mémoire (M) connectant le drain (13), comprenant :
- une première électrode (E1) comprenant une ligne (211), un via (221), et une deuxième portion (32b) de la couche d'arrêt intercalée entre les deux,
- une couche (31) à base d'un matériau diélectrique ou ferroélectrique couvrant la ligne (211) et le via (221),
- une deuxième électrode (E2) surmontant la couche (31),

• une interconnexion (I) connectant la grille (10), comprenant :
une ligne (212), un via (222), et une troisième portion (32c) de la couche d'arrêt intercalée entre les deux.

## Description

### DOMAINE TECHNIQUE

La présente invention concerne le domaine technique des dispositifs mémoire pour la microélectronique. Elle trouve pour application particulièrement avantageuse la formation de dispositifs mémoire non-volatile intégrés dans les niveaux de fin de ligne d'une puce microélectronique.

### ETAT DE LA TECHNIQUE

Les mémoires non-volatiles, par exemple les mémoires résistives à base d'oxyde de type OxRAM (acronyme anglais de « Oxide-Based Random Access Memories ») ou les mémoires ferroélectriques de type FeRAM (acronyme de « Ferroelectric Random Access Memory »), sont actuellement développées dans le but de remplacer les mémoires de type Flash. Ces dispositifs mémoires présentent notamment pour avantage d'être intégrables avec le procédé de fin de ligne BEOL (acronyme anglais de « Back-End Of Line ») de la technologie CMOS (acronyme anglais de « Complementary Metal-Oxide-Semiconductor »).

Les dispositifs mémoires comprennent typiquement une multitude de cellules mémoire agencées sous forme de matrice. Pour une mémoire résistive, chaque cellule mémoire comprend typiquement un élément mémoire résistif (« 1R ») associé à un transistor de sélection (« 1T »), selon une configuration dite « 1T1R ». L'élément mémoire résistif peut commuter de manière réversible entre deux états de résistance LRS (acronyme anglais pour « Low Resistive State ») et HRS (acronyme anglais pour « High Resistive State »), qui correspondent à des valeurs logiques « 0 » et « 1 » utilisées pour coder un bit d'information. Avant d'obtenir ces deux états de résistance LRS et HRS, il est généralement nécessaire d'appliquer une tension dite de « forming » pour conditionner la couche d'oxyde de l'élément mémoire résistif. Cette tension de forming est significativement plus élevée que les tensions de fonctionnement associées aux états LRS et HRS. Un enjeu pour ce type de mémoire OxRAM est de minimiser cette tension de forming.

La cellule élémentaire d'une mémoire FeRAM comprend notamment un condensateur ferroélectrique dans lequel l'information est stockée sous la forme de l'état de polarisation des dipôles électriques. Là encore, le condensateur ferroélectrique HfO2 est connecté au drain d'un transistor de sélection. Un enjeu pour ce type de mémoire FeRAM est de réduire la taille des cellules mémoires tout en conservant une plage de fonctionnement du condensateur ferroélectrique accessible au transistor de sélection.

Un objet de la présente invention est de répondre à ces enjeux, en palliant tout ou partie des inconvénients mentionnés ci-dessus.

En particulier, un objet de la présente invention est de proposer un dispositif mémoire non volatile intégré dans les niveaux de fin de ligne d'une puce microélectronique. Un autre objet de la présente invention est de proposer un procédé de formation d'un tel dispositif.

### RESUME

Pour atteindre cet objectif, selon un mode de réalisation on prévoit un dispositif mémoire non volatile comprenant en empilement suivant une direction z :
- un élément de sélection comprenant au moins deux électrodes,
- une interconnexion connectant l'une desdites au moins deux électrodes,
- un élément mémoire comprenant :
   - une première électrode connectant l'autre desdites au moins deux électrodes de l'élément de sélection, la première électrode comprenant :
      - une ligne métallique à base d'un premier métal et,
      - un via métallique à base d'un deuxième métal,
      - une portion d'une couche d'arrêt de gravure intercalée entre le via et la ligne, ladite portion comprenant au moins une ouverture de via de sorte que le via et la ligne sont connectés au travers de ladite au moins une ouverture de via,
   - une couche à base d'un matériau diélectrique ou ferroélectrique couvrant la ligne et le via,
   - une deuxième électrode surmontant la couche à base du matériau diélectrique ou ferroélectrique.

Un tel dispositif mémoire présente avantageusement un élément mémoire intégré dans les niveaux d'interconnexions « Back End » comprenant typiquement des lignes et des vias métalliques.

Avantageusement, la couche à base d'un matériau diélectrique ou ferroélectrique couvre la ligne et le via formant la première électrode de l'élément mémoire. Elle présente typiquement une forme tridimensionnelle enveloppant la première électrode. Cela permet d'augmenter la surface de la couche à base d'un matériau diélectrique ou ferroélectrique.

Lorsque cette couche est à base d'un matériau diélectrique, un dispositif mémoire de type OxRAM est typiquement formé. En augmentant la surface de la couche à base d'un matériau diélectrique d'un dispositif mémoire OxRAM, la tension de forming est avantageusement diminuée.

Lorsque cette couche est à base d'un matériau ferroélectrique, un dispositif mémoire de type FeRAM est typiquement formé. En augmentant la surface de la couche à base d'un matériau ferroélectrique d'un dispositif mémoire FeRAM, la plage de fonctionnement du condensateur ferroélectrique accessible au transistor de sélection est étendue. Cela permet de compenser la réduction en taille du dispositif mémoire FeRAM. L'intégration du dispositif mémoire FeRAM est améliorée.

L'invention prévoit également selon un deuxième aspect un procédé de fabrication d'un tel dispositif mémoire non volatile. Le procédé comprend :
- une fourniture d'un élément de sélection comprenant au moins deux électrodes présentant chacune une face exposée au niveau d'une surface supérieure,
- une formation d'une première couche métallique sur les faces exposées de la surface supérieure,
- une formation, sur la première couche métallique, d'une couche d'arrêt de gravure, ladite couche d'arrêt de gravure présentant de préférence une sélectivité à la gravure S_{21:30} supérieure ou égale à 5:1 vis-à-vis de la première couche métallique,
- une structuration de la couche d'arrêt de gravure, par l'intermédiaire d'un premier masque, de façon à exposer des parties de la première couche métallique et à conserver des parties de la couche d'arrêt de gravure sous forme d'une portion surmontant l'une desdites au moins deux électrodes de l'élément de sélection, ladite portion comprenant une ouverture de via débouchant sur la première couche métallique sous-jacente,
- une formation d'une deuxième couche métallique sur la portion de la couche d'arrêt de gravure et sur les parties exposées de la première couche métallique,
- une formation, sur la deuxième couche métallique, d'un deuxième masque définissant au moins un via à l'aplomb de l'ouverture de via de la portion de la couche d'arrêt de gravure, et au moins en partie une interconnexion à l'aplomb de l'autre desdites au moins deux électrodes de l'élément de sélection,
- une gravure de la deuxième couche métallique, ladite gravure étant configurée pour former, en s'arrêtant sur la portion de la couche d'arrêt de gravure, un via à l'aplomb de l'ouverture de via de ladite portion, et au moins en partie l'interconnexion,
- une gravure de la première couche métallique de part et d'autre de la portion de la couche d'arrêt de gravure, ladite gravure étant configurée pour former, en s'arrêtant sur la surface supérieure, une ligne métallique sous ladite portion, le via et la ligne métallique formant une première électrode d'un élément mémoire du dispositif, ladite gravure étant de préférence configurée pour former en outre

l'interconnexion,
- une formation d'une couche à base d'un matériau diélectrique ou ferroélectrique sur la première électrode,
- une formation d'une troisième couche métallique sur la couche à base d'un matériau diélectrique ou ferroélectrique,
- une formation, sur la troisième couche métallique, d'un troisième masque définissant au moins un via à l'aplomb de l'interconnexion, et définissant une deuxième électrode de l'élément mémoire à l'aplomb de la couche à base d'un matériau diélectrique ou ferroélectrique,
- une gravure de la troisième couche métallique ladite gravure étant configurée pour former ou reformer l'interconnexion, ladite gravure étant configurée pour former, en s'arrêtant sur la surface supérieure ou sur la couche à base d'un matériau diélectrique ou ferroélectrique, la deuxième électrode de l'élément mémoire.

Les avantages décrits ci-dessus en regard du dispositif s'appliquent *mutatis mutandis* au procédé selon l'invention. Selon une possibilité avantageuse, la gravure de la deuxième couche métallique et la gravure de la première couche métallique sont enchainées selon une seule et même séquence de gravures. Cela permet de limiter le nombre d'étapes du procédé.

### BREVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
Les figures 1A à 19A illustrent schématiquement en coupe transverse, dans un plan xz, différentes étapes du procédé de fabrication d'un dispositif mémoire non volatile 3D selon un mode de réalisation de la présente invention.
Les figures 1B à 19B illustrent schématiquement en perspective, les étapes du procédé de fabrication du dispositif mémoire non volatile 3D illustrées respectivement aux figures 1A à 19A, selon un mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs et/ou les dimensions des différentes couches et motifs ne sont pas représentatives de la réalité. Pour des raisons de clarté, l'ensemble des références alphanumériques n'est pas systématiquement repris d'une figure à l'autre. Il est entendu que les éléments déjà décrits et référencés, lorsqu'ils sont reproduits sur une autre figure, portent typiquement les mêmes références alphanumériques, même si celles-ci ne sont pas explicitement mentionnées. L'homme du métier identifiera sans difficultés un même élément reproduit sur différentes figures.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement.

Selon un exemple, la couche à base d'un matériau diélectrique ou ferroélectrique présente au moins une portion dite horizontale, s'étendant perpendiculairement à la direction z, séparant les première et deuxième électrodes, et au moins une portion dite verticale, s'étendant parallèlement à la direction z, séparant les première et deuxième électrodes. La couche à base d'un matériau diélectrique ou ferroélectrique présente typiquement une forme tridimensionnelle entourant la première électrode, et entourée par la deuxième électrode. La surface de couche interfacée entre les première et deuxième électrodes est augmentée.

Selon un exemple, l'au moins une portion horizontale comprend une première portion horizontale sur le via métallique de la première électrode et une deuxième portion horizontale sur la portion de la couche d'arrêt de gravure de l'élément mémoire. La portion de la couche d'arrêt de gravure correspond à un élément résiduel lié à la mise en oeuvre du procédé selon l'invention, permettant de fabriquer le dispositif selon l'invention. Cet élément résiduel dans le dispositif peut donc être un indicateur de mise en œuvre du procédé selon l'invention.

Selon un exemple, l'au moins une portion verticale comprend une première portion verticale sur au moins un flanc du via métallique de la première électrode et une deuxième portion verticale sur au moins un flanc de la ligne métallique de la première électrode.

Selon un exemple, le via métallique de la première électrode de l'élément mémoire présente une dimension critique CDᵥᵢₐ₂₂₁, prise selon un axe x perpendiculaire à la direction z, supérieure ou égale à une dimension CDₒₚₑₙ de l'au moins une ouverture de via prise selon l'axe x. Cela permet d'introduire une certaine tolérance dans l'alignement entre les premier et deuxième masques. Le via étant typiquement plus large que l'ouverture de via sous-jacente, l'alignement du deuxième masque définissant les vias à l'aplomb des ouvertures de via est facilité. La gravure de la deuxième couche métallique, lors de la formation des vias, s'arrêtera effectivement sur la couche d'arrêt de gravure, structurée selon la deuxième portion. La gravure de la deuxième couche métallique ne se prolonge pas au niveau des ouvertures de via. Le risque lié à un désalignement entre les premier et deuxième masques est minimisé. La fiabilité du procédé est augmentée.

Selon un exemple, le via métallique de la première électrode de l'élément mémoire présente une dimension critique CDᵥᵢₐ₂₂₁, prise selon un axe x, sensiblement égale à une dimension CD_{ligne}, prise selon l'axe x, de la ligne métallique de la première électrode de l'élément mémoire, de sorte que la deuxième portion de la couche d'arrêt de gravure est prise en sandwich entre le via et la ligne.

Selon un exemple, la ou les lignes métalliques présentent une dimension critique CD_{ligne}, prise selon un axe x, sensiblement égale à une dimension CD₁, prise selon l'axe x, de la ou des portions de la couche d'arrêt de gravure associées auxdites lignes.

Selon un exemple, la couche à base d'un matériau diélectrique ou ferroélectrique est à base d'un matériau pris parmi : HfₓZr₁₋ₓO₂, HfO₂ dopé ou non dopé. HfO₂ est un oxyde métallique qui peut présenter avantageusement des propriétés diélectriques et/ou ferroélectriques, en fonction de son épaisseur notamment et de son niveau de dopage.

Selon un exemple, la couche à base d'un matériau diélectrique ou ferroélectrique est à base d'un matériau ferroélectrique pris parmi : HfₓZr₁₋ₓO₂, HfO₂ dopé par l'un au moins parmi les éléments dopants suivants : Si, N, Gd, Y, Sc, Ge, avec une concentration en éléments dopants comprise entre 0,5% et 10%at., préférentiellement entre 0,5% et 3%at.

Selon un exemple, la couche à base d'un matériau diélectrique ou ferroélectrique est à base d'un matériau diélectrique pris parmi : HfOₓ, TaOₓ avec 1,8 ≤ x ≤ 2. HfOₓ peut être dans ce cas faiblement dopé (typiquement avec une concentration en éléments dopants inférieure à 0,5%at.) ou non dopé.

Selon un exemple, la couche d'arrêt de gravure présente une épaisseur e₃₀ₐ comprise entre 2 nm et 15 nm, préférentiellement entre 7 nm et 10 nm.

Selon un exemple, l'élément de sélection est pris parmi : un transistor à effet de champ ou un transistor ferroélectrique à effet de champ, une diode, un sélecteur.

Selon un exemple, la couche à base d'un matériau diélectrique ou ferroélectrique présente une épaisseur e_{30b} comprise entre 2 nm et 15 nm, préférentiellement entre 7 nm et 10 nm.

Selon un exemple, le dispositif mémoire non volatile comprend en empilement suivant une direction z :
- un transistor comprenant une grille surmontant un canal, une source et un drain de part et d'autre du canal,
- une interconnexion connectant la source, comprenant :
   - une ligne métallique à base d'un premier métal, connectée à la source et,
   - un via métallique à base d'un deuxième métal, connecté à ladite au moins une ligne métallique,
   - une première portion d'une couche d'arrêt de gravure intercalée entre le via et la ligne, ladite couche d'arrêt de gravure présentant une sélectivité à la gravure S21:30 supérieure ou égale à 5:1 vis-à-vis du premier métal, ladite première portion comprenant au moins une ouverture de via de sorte que le via et la ligne sont connectés au travers de ladite au moins une ouverture de via,
- un élément mémoire connectant le drain, comprenant :
   - une première électrode connectée au drain comprenant :
      - une ligne métallique à base du premier métal et,
      - un via métallique à base du deuxième métal,
      - une deuxième portion de la couche d'arrêt de gravure intercalée entre le via et la ligne, ladite deuxième portion comprenant au moins une ouverture de via de sorte que le via et la ligne sont connectés au travers de ladite au moins une ouverture de via,
   - une couche à base d'un matériau diélectrique ou ferroélectrique couvrant la ligne et le via,
   - une deuxième électrode surmontant la couche à base du matériau diélectrique ou ferroélectrique,
- une interconnexion connectant la grille, comprenant :
   - une ligne métallique à base du premier métal, connectée à la grille et,
   - un via métallique à base du deuxième métal,
   - une troisième portion de la couche d'arrêt de gravure intercalée entre le via et la ligne, ladite troisième portion comprenant au moins une ouverture de via de sorte que le via et la ligne sont connectés au travers de ladite au moins une ouverture de via.

Selon un exemple, la gravure de la deuxième couche métallique et la gravure de la première couche métallique sont enchainées selon une seule et même séquence de gravures. Cette séquence de gravures peut comporter plusieurs sous-étapes avec des conditions plasma différentes par exemple.

Selon un exemple, la gravure de la deuxième couche métallique et la gravure de la première couche métallique sont réalisées par une seule et même gravure, lors d'une seule et même étape. Les conditions de gravure restent sensiblement identiques lors de la gravure des deuxième et première couches métalliques. Cela permet de réduire la durée et/ou les coûts du procédé.

Selon un exemple, la formation de la couche à base du matériau diélectrique ou ferroélectrique comprend :
- un dépôt conforme de la couche à base du matériau diélectrique ou ferroélectrique sur la première électrode et sur l'interconnexion, puis
- une structuration par lithographie et gravure de façon à retirer des parties de la couche à base du matériau diélectrique ou ferroélectrique déposées sur l'interconnexion, et à conserver une partie de la couche à base du matériau diélectrique ou ferroélectrique déposée sur la première électrode.

Selon un exemple alternatif, la formation de la couche à base du matériau diélectrique ou ferroélectrique comprend :
- une formation d'une couche de protection sur l'interconnexion, puis
- un dépôt localisé de la couche à base du matériau diélectrique ou ferroélectrique sur la première électrode,
- un retrait de ladite couche de protection.

Selon un exemple, le procédé comprend en outre, après formation de la couche à base du matériau diélectrique ou ferroélectrique, un dépôt d'une couche barrière à la diffusion, par exemple à base de titane.

Selon un exemple, la formation du premier masque se fait par double lithographie. Ce procédé connu de lithographie permet d'optimiser, voire de dépasser les limitations en résolution d'un équipement d'insolation classique de lithographie. Une autre solution consiste à utiliser un équipement de lithographie mieux résolu, par exemple en extrême UV ou en lithographie électronique. La formation du premier masque peut comprendre une première lithographie suivie d'une deuxième lithographie, puis une gravure. Alternativement, la formation du premier masque peut comprendre une première lithographie suivie d'une première gravure, puis une deuxième lithographie suivie d'une deuxième gravure.

Selon un exemple, le premier métal et/ou le deuxième métal sont à base d'au moins l'un parmi : TiN, TaN, W, Ru, Ta, AI.

Selon un exemple, les premier et deuxième métaux sont à base du même matériau.

Selon un exemple, la couche d'arrêt de gravure est à base d'un matériau pris parmi : SiO₂, TiO₂, HfO₂, HfN, ZrN, SiN, SiCN. Cela permet d'obtenir une sélectivité S_{21:30} à la gravure entre le premier métal et le matériau de la couche d'arrêt de gravure supérieure ou égale à 5:1. La vitesse de gravure de la couche d'arrêt de gravure est au moins cinq fois inférieure à la vitesse de gravure de la première couche métallique. Selon un exemple, la sélectivité S_{21:30} est supérieure à 10:1.

Selon un exemple, le procédé comprend :
- une fourniture d'un transistor comprenant une grille surmontant un canal, une source et un drain de part et d'autre du canal, et des vias connectant la source et le drain, lesdits vias et ladite grille présentant chacun une face exposée au niveau d'une surface supérieure,
- une formation d'une première couche métallique sur les faces exposées de la surface supérieure,
- une formation, sur la première couche métallique, d'une couche d'arrêt de gravure présentant une sélectivité à la gravure S_{21:30} supérieure ou égale à 5:1 vis-à-vis de la première couche métallique,
- une structuration de la couche d'arrêt de gravure, par l'intermédiaire d'un premier masque, de façon à exposer des parties de la première couche métallique et à conserver des parties de la couche d'arrêt de gravure sous forme de première et deuxième portions surmontant chacun des vias connectant la source et le drain, et d'une troisième portion surmontant la grille du transistor, lesdites première, deuxième et troisième portions comprenant chacune une ouverture de via débouchant sur la première couche métallique sous-jacente,
- une formation d'une deuxième couche métallique sur les première, deuxième et troisième portions de la couche d'arrêt de gravure et sur les parties exposées de la première couche métallique,
- une formation, sur la deuxième couche métallique, d'un deuxième masque définissant des vias à l'aplomb des ouvertures de via des première, deuxième et troisième portions de la couche d'arrêt de gravure,
- une gravure de la deuxième couche métallique, ladite gravure étant configurée pour former, en s'arrêtant sur les première, deuxième et troisième portions de la couche d'arrêt de gravure, respectivement un premier via à l'aplomb de l'ouverture de via de la première portion, un deuxième via à l'aplomb de l'ouverture de via de la deuxième portion, un troisième via à l'aplomb de l'ouverture de via de la troisième portion,
- une gravure de la première couche métallique de part et d'autre des première,

deuxième et troisième portions de la couche d'arrêt de gravure, ladite gravure étant configurée pour former, en s'arrêtant sur la surface supérieure, une première ligne métallique sous la première portion, une deuxième ligne métallique sous la deuxième portion, une troisième ligne métallique sous la troisième portion, le deuxième via et la deuxième ligne métallique formant une première électrode d'un élément mémoire du dispositif,
- une formation d'une couche à base d'un matériau diélectrique ou ferroélectrique sur la première électrode,
- une formation d'une troisième couche métallique sur la couche à base d'un matériau diélectrique ou ferroélectrique et sur les deuxième et troisième vias,
- une formation, sur la troisième couche métallique, d'un troisième masque définissant des vias à l'aplomb des ouvertures de via des première et troisième portions de la couche d'arrêt de gravure, et définissant une deuxième électrode de l'élément mémoire à l'aplomb de la couche à base d'un matériau diélectrique ou ferroélectrique,
- une gravure de la troisième couche métallique ladite gravure étant configurée pour former ou reformer, en s'arrêtant sur les première et troisième portions de la couche d'arrêt de gravure, respectivement le premier via à l'aplomb de l'ouverture de via de la première portion, le troisième via à l'aplomb de l'ouverture de via de la troisième portion, ladite gravure étant configurée pour former, en s'arrêtant sur la surface supérieure ou sur la couche à base d'un matériau diélectrique ou ferroélectrique, la deuxième électrode de l'élément mémoire.

Sauf incompatibilité, il est entendu que l'ensemble des caractéristiques optionnelles ci-dessus et/ou les variantes indiquées peuvent être combinées de façon à former un mode de réalisation qui n'est pas nécessairement illustré ou décrit. Un tel mode de réalisation n'est évidemment pas exclu de l'invention.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt ou l'application d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

On entend par un substrat, un film, une couche, « à base » d'un matériau A, un substrat, un film, une couche comprenant ce matériau A uniquement ou ce matériau A et éventuellement d'autres matériaux, par exemple des éléments dopants ou des éléments d'alliage. Ainsi, un espaceur à base de nitrure de silicium SiN peut par exemple comprendre du nitrure de silicium non stœchiométrique (SiN), ou du nitrure de silicium stœchiométrique (Si₃N₄), ou encore un oxy-nitrure de silicium (SiON) ou un carbonitrure de silicium (SiCN).

Le mot « diélectrique » qualifie un matériau dont la conductivité électrique est suffisamment faible dans l'application donnée pour servir d'isolant. Dans la présente invention, un matériau diélectrique présente de préférence une constante diélectrique inférieure à 20, et de préférence inférieure à 10.

La couche diélectrique d'une mémoire résistive OxRAM est par exemple une couche d'oxyde métallique à base de HfO₂ disposée entre les deux électrodes de l'élément mémoire. Contrairement à la présente invention, une solution connue permettant de diminuer la tension de forming d'une telle mémoire OxRAM consiste à implanter du silicium dans la couche d'oxyde métallique à base de HfO₂, comme divulgué dans le document « 16kbit 1T1R OxRAM arrays embedded in 28nm FDSOI technology demonstrating low BER, high endurance, and compatibility with core logic transistors, L. Grenouillet et al, IMW 2021 »

Lorsque le matériau HfO₂ est déposé en couches minces, celui-ci présente avantageusement des propriétés ferroélectriques. Il est donc également possible d'envisager la fabrication d'un dispositif mémoire de type FeRAM selon le principe de la présente invention.

La présente invention s'adresse plus généralement à la fabrication de tous types de mémoires non-volatiles tridimensionnelles ou 3D.

Plusieurs modes de réalisation de l'invention mettant en œuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé. Les gravures des première et deuxième couches métalliques peuvent notamment être enchaînées ou être considérées comme faisant partie d'une seule et même étape de gravure.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B. Elle est notée S_{A:B}. Une sélectivité S_{A:B} de 10:1 signifie que la vitesse de gravure du matériau A est 10 fois supérieure à la vitesse de gravure du matériau B.

Un repère de préférence orthonormé, comprenant les axes x, y, z est représenté sur les figures annexées.

Dans la présente demande de brevet, on parlera préférentiellement d'épaisseur pour une couche ou un film, et de hauteur pour un dispositif ou une structure. L'épaisseur est prise selon une direction normale au plan d'extension principal de la couche ou du film. Ainsi, une couche métallique présente typiquement une épaisseur selon z. Un via formé à partir d'une telle couche métallique présente une hauteur selon z. Les termes relatifs « sur », « surmonte », « supérieur », « sous », « sous-jacent » « inférieur » se réfèrent à des positions prises selon la direction z. Une dimension « latérale » correspond à une dimension selon une direction du plan xy. On entend par une extension « latérale » ou « latéralement », une extension selon une ou des directions du plan xy.

Un élément situé « à l'aplomb » ou « au droit d' » un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures en coupe transverse.

Les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

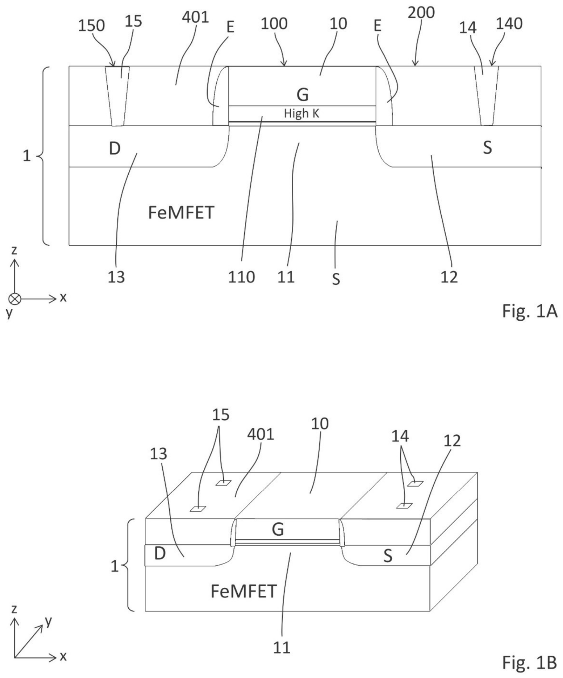

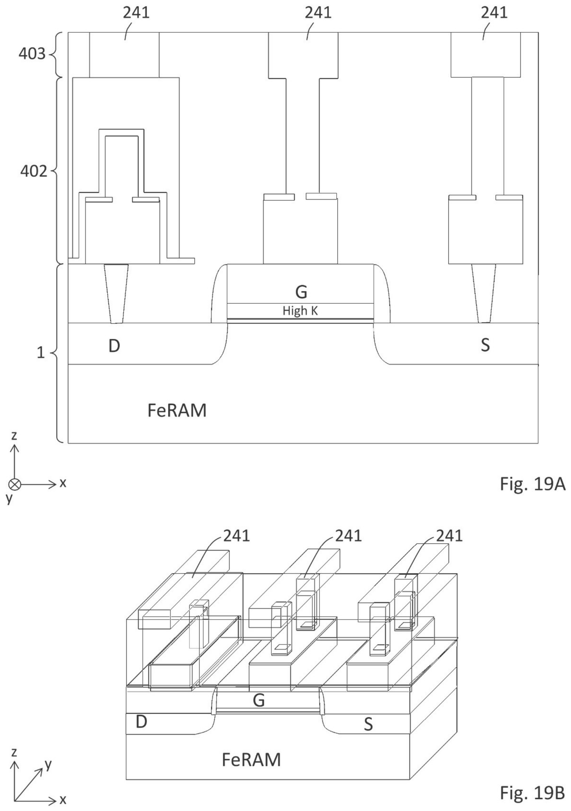

Des étapes de fabrication d'un dispositif mémoire non-volatile 3D selon un mode de réalisation de l'invention sont illustrées aux figures 1A, 1B à 19A, 19B.

Comme illustré aux figures 1A, 1B, le procédé comprend une fourniture d'un transistor 1 par exemple de type MOS (métal-oxyde-semiconducteur). Ce transistor 1 comprend typiquement un substrat S à base de silicium, une grille 10 surmontant le substrat S, une source 12 et un drain 13 de part et d'autre de la grille 10, par exemple au sein du substrat S, et un canal 11 sous la grille 10 et séparé de la grille 10 par une ou plusieurs couches diélectriques 110. La grille 10 est typiquement flanquée par des espaceurs E.

Le transistor 1 comprend ici également les vias 14, 15 connectant respectivement la source 12 et le drain 13 du transistor. Ces vias 14, 15 sont de préférence obtenus selon une approche « damascène ». Selon cette approche, après formation de la grille 10 et des source 12 et drain 13 du transistor, une couche diélectrique 401 est déposée. Cette couche diélectrique 401 est typiquement planarisée par polissage mécano-chimique CMP de façon à exposer une face supérieure 100 de la grille 10. Des ouvertures débouchant sur les source 12 et drain 13 du transistor sont formées au sein de la couche diélectrique 401, puis remplies par un métal. Une planarisation, par exemple par CMP, est effectuée de façon à retirer le métal en surface de la couche diélectrique 401 et de la face supérieure de la grille 10. Les vias 14, 15 sont ainsi obtenus. Ils présentent respectivement des faces exposées 140, 150 coplanaires avec la face supérieure 100 de la grille 10. La surface supérieure 200 de ce transistor 1, comprenant les faces exposées 140, 150, 100, est avantageusement plane.

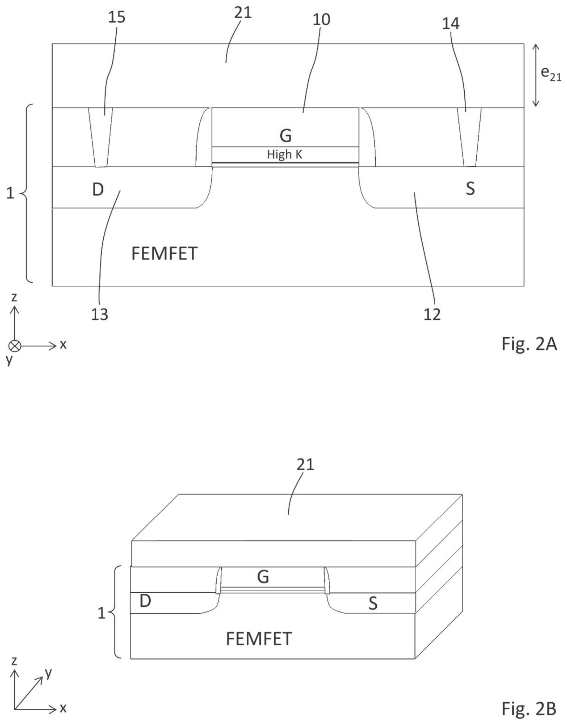

Comme illustré aux figures 2A, 2B, une première couche métallique 21, typiquement à base d'un métal pris parmi TaN, **TiN,** AI, Ru, Mo, W est d'abord formée sur la surface 200 du transistor 1. Les vias 14, 15 et la grille 10 sont directement en contact avec la couche métallique 21. Cette couche métallique 21 présente typiquement une épaisseur e₂₁ de l'ordre de quelques dizaines de nanomètres à quelques centaines de nanomètres, par exemple entre 20 nm et 200 nm. Le dépôt de cette couche métallique 21 peut notamment être effectué par l'une des techniques suivantes: dépôt physique en phase vapeur (PVD, acronyme de « physical vapor deposition »), dépôt chimique en phase vapeur (CVD, acronyme de « chemical vapor deposition »), dépôt par couche atomique (ALD, acronyme de « atomic layer deposition »). Après dépôt, la première couche métallique 21 peut être planarisée, par exemple par CMP. La première couche métallique 21 correspond typiquement à un premier niveau de métal.

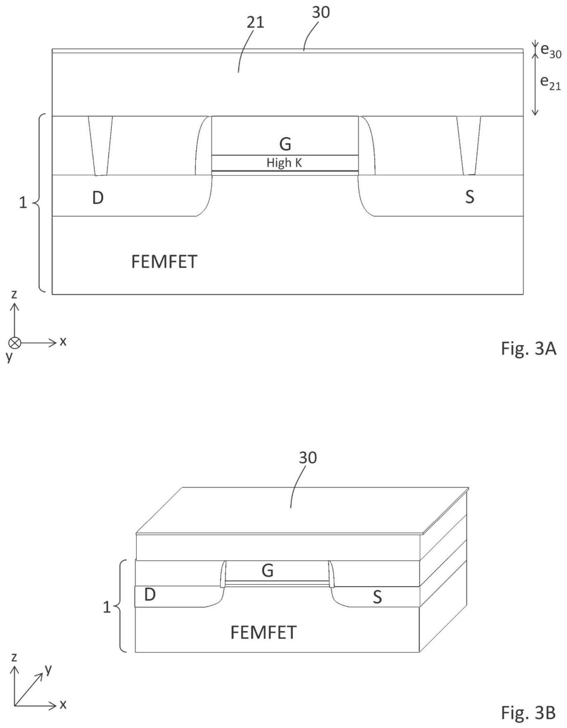

Comme illustré aux figures 3A, 3B, une couche d'arrêt de gravure 30 est ensuite directement formée sur la première couche métallique 21. Cette couche d'arrêt de gravure 30 présente typiquement une épaisseur e₃₀ de l'ordre de quelques nanomètres, par exemple entre 2 nm et 15 nm. Elle est de préférence à base d'un matériau diélectrique pris parmi : SiO₂, TiO₂, HfO₂, HfN, ZrN, SiN, SiCN. Le dépôt de cette couche d'arrêt de gravure 30 est de préférence effectué par ALD.

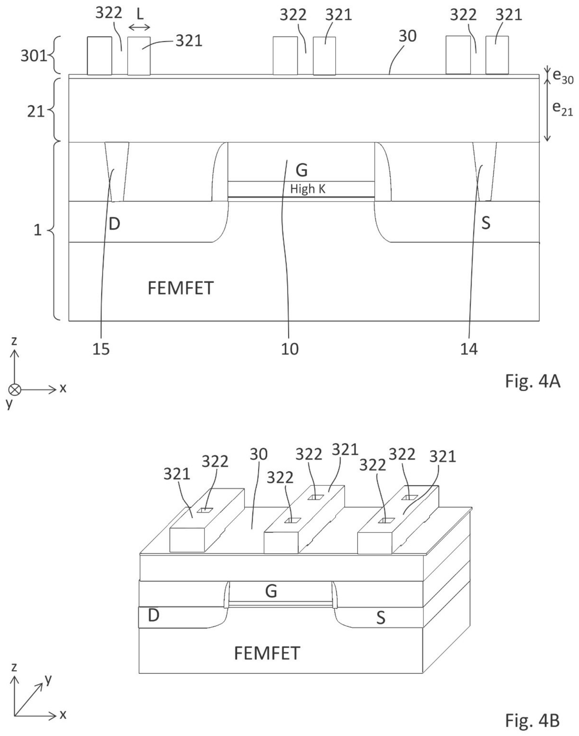

Comme illustré aux figures 4A, 4B, un masque de gravure 301 est formé sur la couche d'arrêt de gravure 30. Ce masque de gravure 301 est par exemple à base de SiON. Il est typiquement obtenu par lithographie/gravure, par exemple par l'intermédiaire d'une lithographie simple en insolation extrême UV, ou par l'intermédiaire d'une double lithographie, également appelée « double patterning ».

Le masque de gravure 301 comprend des motifs ouverts 321 au-dessus des vias 14, 15 et de la grille 10 du transistor 1. Les motifs ouverts 321 comprennent une ou plusieurs ouvertures 322 débouchant sur la couche d'arrêt de gravure 30 sous-jacente. Les motifs ouverts 321 présentent typiquement une dimension L selon x comprise entre 8 nm et 150 nm, en fonction de la technique de lithographie mise en œuvre.

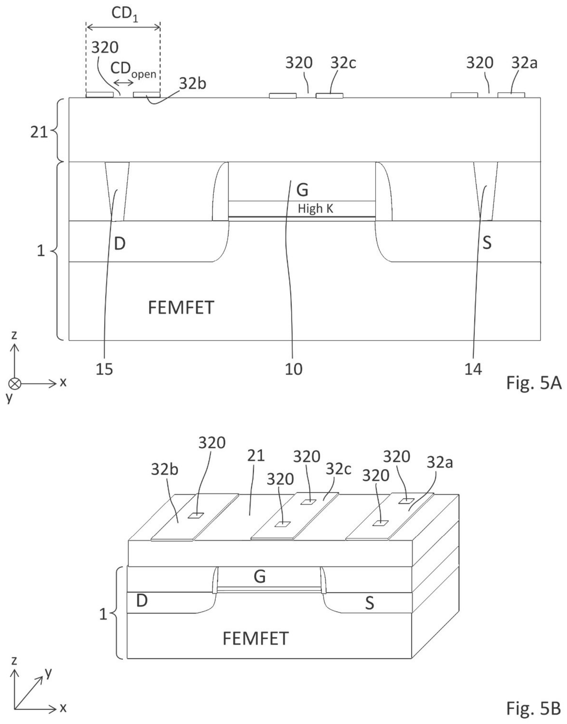

Comme illustré aux figures 5A, 5B, les motifs 321 sont transférés dans la couche d'arrêt de gravure 30 par gravure anisotrope selon z de la couche d'arrêt de gravure 30 en présence du masque 301. Cette gravure peut présenter une chimie de gravure halogénée à base de chlore ou de fluor, selon le type de masque 301 et la nature de la couche d'arrêt de gravure 30. Pour une couche d'arrêt de gravure 30 à base d'hafnium, la gravure peut se faire à partir d'une chimie de gravure BCl₃. Pour une couche d'arrêt de gravure 30 à base de silicium, la gravure peut se faire à partir d'une chimie de gravure fluorocarbonnée, par exemple CF₄. Après gravure, les portions 32a, 32b, 32c comprenant les ouvertures de via 320 sont formées à partir de la couche d'arrêt de gravure 30. Les portions 32a, 32b, 32c présentent sensiblement les mêmes dimensions que les motifs 321. Les portions 32a, 32b, 32c présentent typiquement une dimension CD₁ selon x, et les ouvertures de via 320 présentent typiquement une dimension CDₒₚₑₙ selon x. Les portions 32a, 32b, 32c peuvent présenter chacune les mêmes dimensions CD₁, CDₒₚₑₙ. Alternativement, les portions 32a, 32b, 32c peuvent présenter respectivement des dimensions CD₁ₐ, CD_{open_a}, CD_{1b}, CD_{open_b}, CD_{1c}, CD_{open_c} différentes les unes des autres. Le masque 301 est retiré après gravure, par exemple par plasma à base d'oxygène.

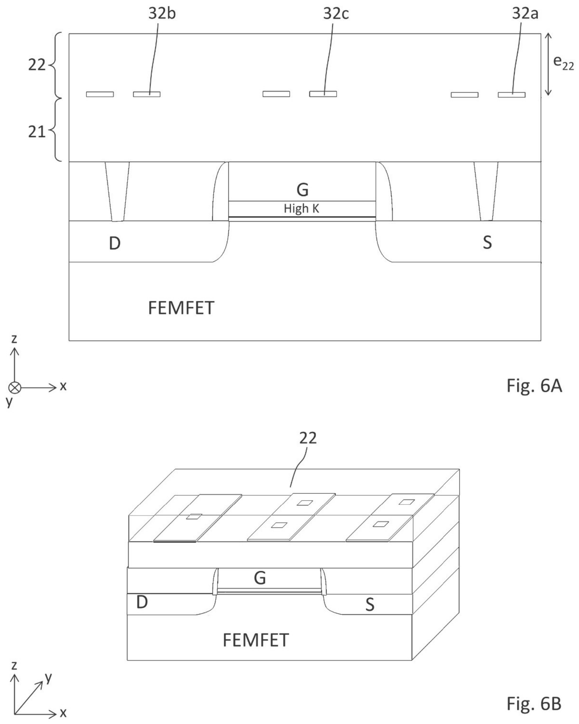

Comme illustré aux figures 6A, 6B, après structuration de la couche d'arrêt de gravure 30, une deuxième couche métallique 22, typiquement à base d'un métal pris parmi TaN, TiN, AI, Ru, Mo, W, est ensuite formée sur la première couche métallique 21, et sur les portions 32a, 32b, 32c. Cette couche métallique 22 présente typiquement une épaisseur e₂₂ de l'ordre de quelques dizaines de nanomètres à quelques centaines de nanomètres, par exemple entre 20 nm et 200 nm. Le dépôt de cette couche métallique 22 peut notamment être effectué par PVD, CVD ou ALD. Après dépôt, la deuxième couche métallique 22 peut être planarisée, par exemple par CMP. La deuxième couche métallique 22 correspond typiquement à un deuxième niveau de métal.

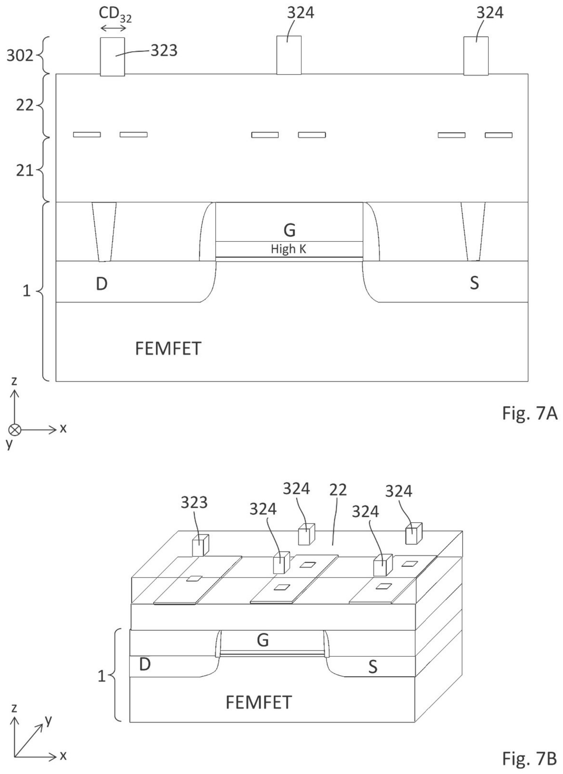

Comme illustré aux figures 7A, 7B, un deuxième masque de gravure 302 comprenant des motifs de vias 323, 324 est formé sur la deuxième couche métallique 22. Ce deuxième masque de gravure 302 est de préférence à base de couches organiques, par exemple sous forme d'un empilement connu sous la dénomination « trilayer », comprenant typiquement une couche de planarisation organique, une couche antireflets et une couche de résine photosensible.

Les motifs de vias 324 de ce deuxième masque de gravure 302 sont alignés à l'aplomb des ouvertures de via 320 des portions 32a, 32c. Le motif de via 323 de ce deuxième masque de gravure 302 est aligné à l'aplomb de la portion 32b. Les motifs de vias 323, 324 présentent typiquement une dimension CD₃₂ selon x légèrement supérieure, par exemple 10% supérieure, à la dimension CDₒₚₑₙ selon x des ouvertures de via 320 des portions 32a, 32b, 32c. Cela facilite l'alignement des motifs 324, 323 et des portions 32a, 32b, 32c entre eux. Une certaine tolérance sur la précision d'alignement est ainsi obtenue. La dimension CD₃₂ selon x des motifs de vias 323, 324 est par exemple comprise entre 10 nm et 150 nm. Selon une possibilité, le motif 323 présente une dimension CD₃₂ selon x supérieure aux dimensions CD₃₂ des motifs 324. Plus généralement, les dimensions selon x et y du motif 323 peuvent différer des dimensions selon x et y des motifs 324.

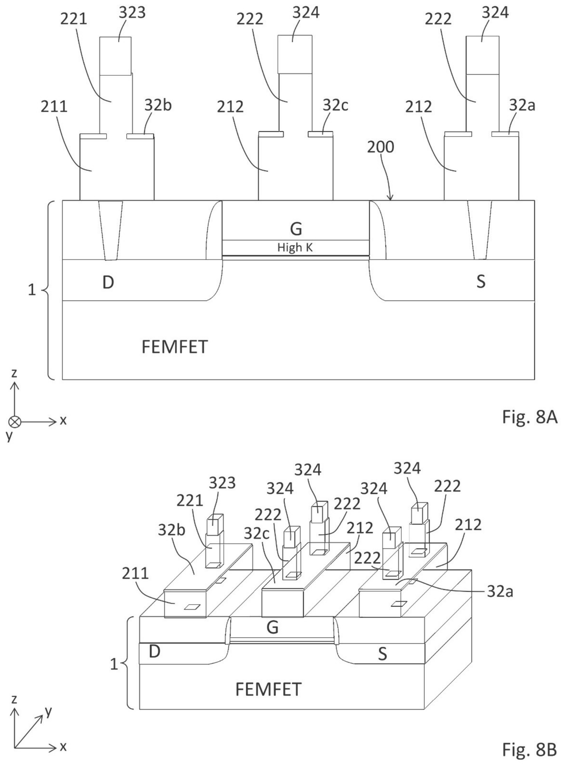

Comme illustré aux figures 8A, 8B, les première et deuxième couches métalliques 21, 22 sont ensuite gravées sur toute leur épaisseur, selon z, de part et d'autre des motifs de vias 323, 324 et de part et d'autre des portions 32a, 32b, 32c. La deuxième couche métallique 22 est d'abord gravée pour former les vias 222, 221, puis la première couche métallique 21 est gravée pour former les lignes 212, 211. Les gravures des première et deuxième couches métalliques 21, 22 sont de préférence enchaînées. Selon une possibilité, notamment lorsque les première et deuxième couches métalliques 21, 22 sont de nature identique, les gravures de ces couches métalliques 21, 22 sont effectuées en une seule et même étape, avec la même chimie de gravure.

Les gravures sont ici choisies de façon à graver sélectivement les premier et deuxième métaux des première et deuxième couches métalliques 21, 22 vis-à-vis du matériau de la couche d'arrêt de gravure 30 (structurée sous forme des portions 32a, 32b, 32c). En particulier, la sélectivité de gravure S_{21:30}, c'est-à-dire le rapport entre la vitesse de gravure du métal de la première couche métallique 21 sur la vitesse de gravure du matériau de la couche d'arrêt de gravure, est supérieure ou égale à 5:1, de préférence supérieure ou égale à 10:1. Les gravures peuvent être à base d'une chimie halogénée, par exemple fluorée si les première et deuxième couches métalliques 21, 22 sont à base de Mo ou de W, ou chlorée si les première et deuxième couches métalliques 21, 22 sont à base de TiN.

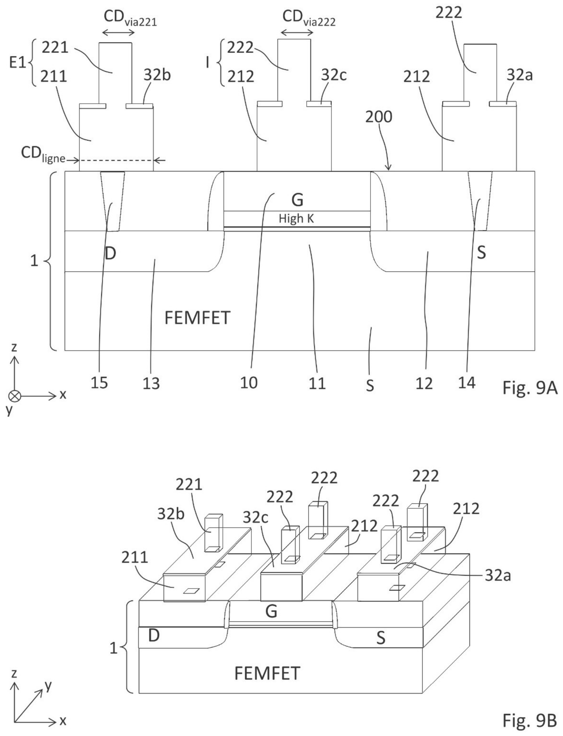

Comme illustré aux figures 9A, 9B, après gravure, le masque 302 est retiré, par exemple par plasma à base d'oxygène. Des vias 222 présentant la dimension CDᵥᵢₐ₂₂₂ selon x sont obtenus au-dessus des portions 32a, 32c. La dimension CDᵥᵢₐ₂₂₂ est sensiblement égale à la dimension CD₃₂ des motifs de vias 324. Un via 221 présentant la dimension CDᵥᵢₐ₂₂₁ selon x est obtenu au-dessus de la portion 32b. Les vias 222, 221 se situent ici dans le deuxième niveau de métal. Des lignes 211, 212 présentant la dimension CD_{ligne} selon x sont également obtenues. La dimension CD_{ligne} est sensiblement égale à la dimension CD₁ des portions 32a, 32b, 32c. Les lignes 211, 212 se situent ici dans le premier niveau de métal. Une première électrode E1 (211, 221) connectée au drain 13 du transistor est ainsi formée. Des interconnexions I (212, 222) connectées respectivement à la source 12 et à la grille 10 du transistor sont ainsi formées.

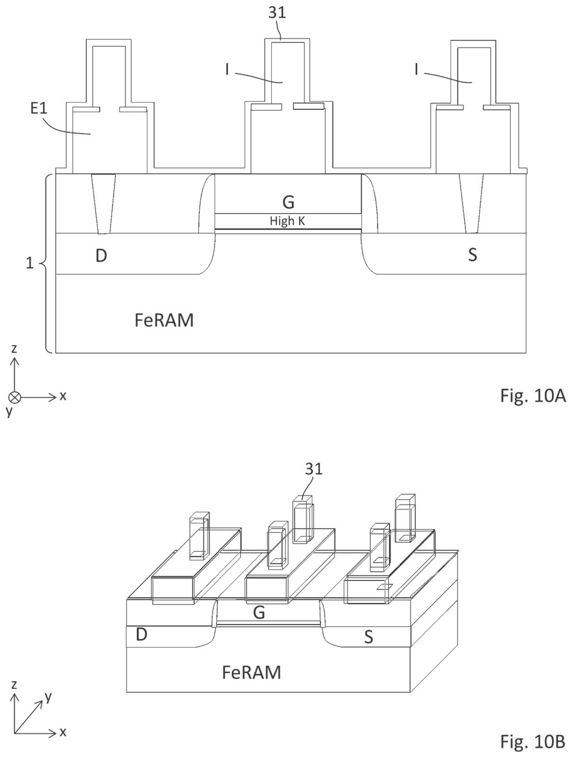

Comme illustré aux figures 10A, 10B, une couche 31 à base d'un matériau diélectrique ou ferroélectrique est ensuite formée sur la première électrode E1 et sur les interconnexions I. Cette couche 31 peut être à base d'un matériau diélectrique, par exemple HfO₂, TaOₓ, ou à base d'un matériau ferroélectrique, par exemple HfₓZr₁₋ₓO₂, HfO₂ dopé. HfO₂ peut typiquement être dopé par l'un au moins parmi les éléments dopants suivants : Si, N, Gd, Y, Sc, Ge, avec une concentration en éléments dopants comprise entre 0,5% et 3%at. de préférence. La couche 31 présente une épaisseur de l'ordre de quelques nanomètres, par exemple comprise entre 2 nm et 15 nm. La couche 31 est de préférence déposée par ALD. La couche 31 à base d'un matériau diélectrique ou ferroélectrique est destinée à former la couche de séparation entre les électrodes d'un élément mémoire, pour une mémoire de type OxRAM ou FeRAM. Elle est donc conservée uniquement sur la première électrode E1 dans le dispositif final.

Selon une possibilité non illustrée, après formation de la couche 31, notamment lorsque celle-ci est à base d'oxyde d'hafnium, un dépôt d'une couche barrière à la diffusion, par exemple à base de titane, peut être effectué.

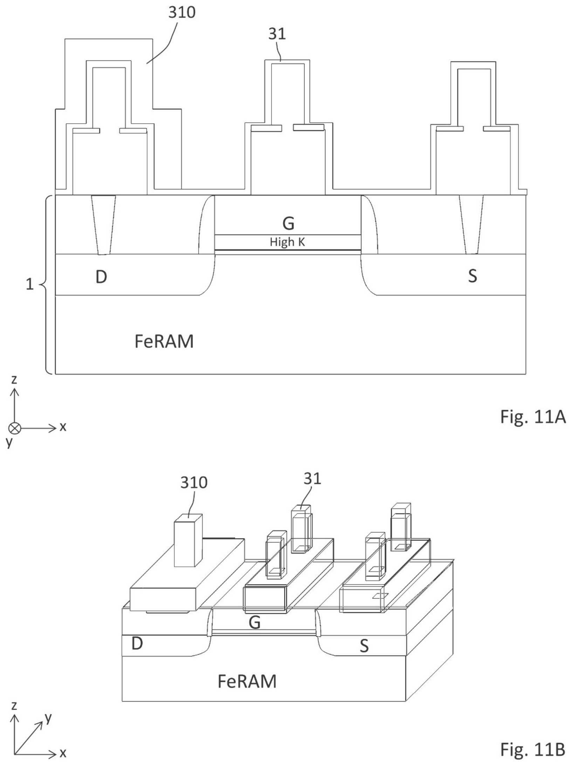

Comme illustré aux figures 11A, 11B, une couche de protection 310 est formée, typiquement par lithographie, sur une partie de la couche 31 couvrant la première électrode E1. Les parties de la couche 31 couvrant les interconnexions I restent exposées.

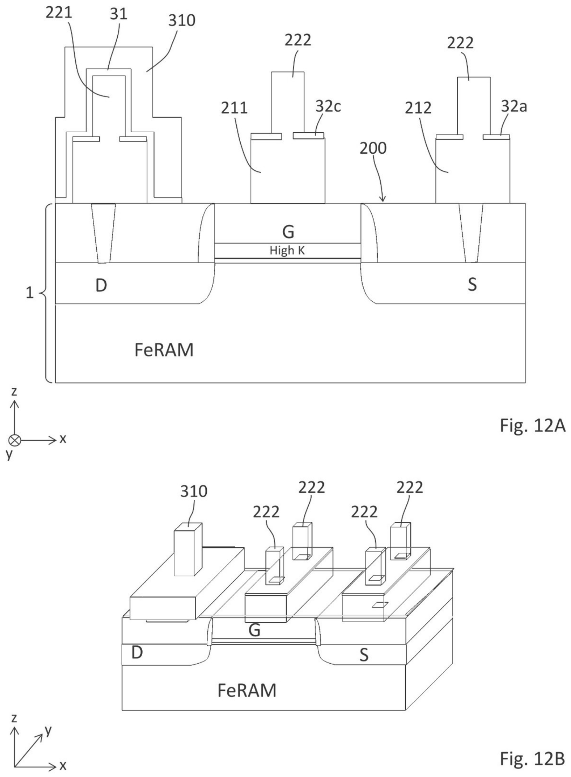

Comme illustré aux figures 12A, 12B, les parties exposées de la couche 31 sont retirées, typiquement par gravure. Les interconnexions I sont à nouveau exposées. La couche 31 est ici structurée par lithographie/gravure. D'autres techniques de structuration sont envisageables.

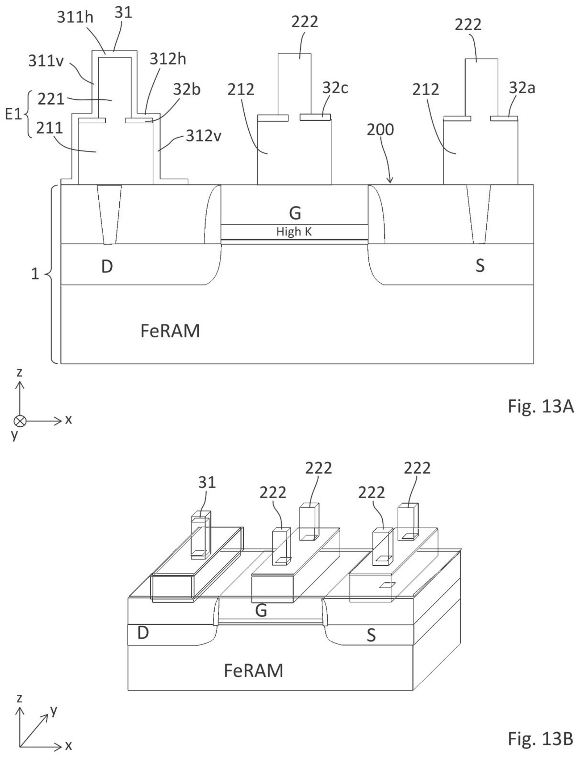

Comme illustré aux figures 13A, 13B, après retrait de la couche de protection 310, une partie de couche 31 couvrant uniquement la première électrode E1 est obtenue. Cette partie de couche 31 présente une forme tridimensionnelle. Comme la dimension CD_{ligne} de la ligne 211 est typiquement supérieure à la dimension CDᵥᵢₐ₂₂₁ du via 221, la couche 31 restante présente un épaulement entre la ligne 211 et le via 221. Cet épaulement s'appuie typiquement sur la portion 32b de couche d'arrêt de gravure. La couche 31 restante comprend typiquement une première portion horizontale 311h au sommet du via 221 et une deuxième portion horizontale 312h sur la deuxième portion 32b de la couche d'arrêt de gravure. La couche 31 restante comprend typiquement également une première portion verticale 311v sur le ou les flancs du via 221 et une deuxième portion verticale 312v sur le ou les flancs de la ligne 211. La surface développée de l'interface entre la couche 31 tridimensionnelle et la première électrode E1 est significativement augmentée en comparaison d'une architecture d'élément mémoire basée sur une couche diélectrique ou ferroélectrique 2D intercalée entre les électrodes (la comparaison étant faite pour une empreinte d'élément mémoire équivalente sur la puce microélectronique).

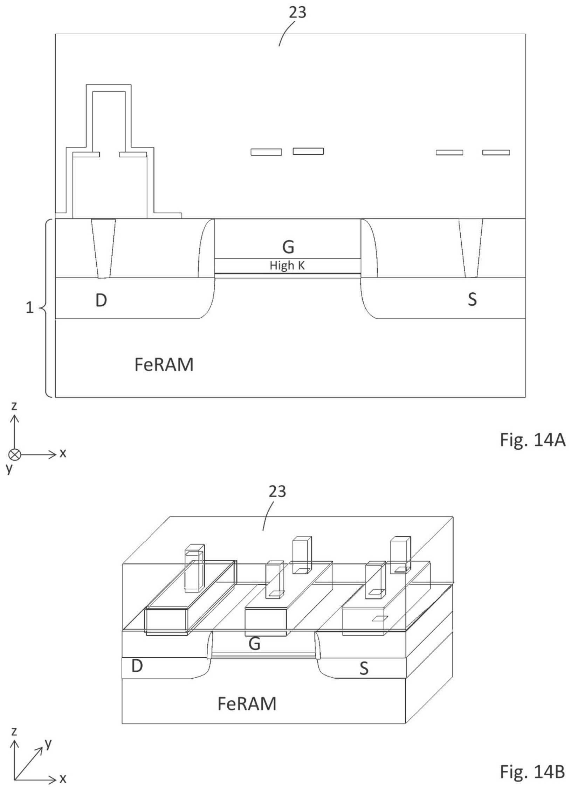

Comme illustré aux figures 14A, 14B, une troisième couche métallique 23 par exemple à base de TaN, TiN, AI, Ru, Mo, est ensuite déposée sur la couche 31 couvrant la première électrode E1 et sur les interconnexions I connectées à la source et à la grille du transistor. Le dépôt peut se faire par PVD, CVD ou ALD par exemple. L'épaisseur de couche 23 déposée peut être comprise entre 30 nm et 600 nm, de façon à remplir entièrement les espaces entre les interconnexions I. Un polissage CMP est typiquement effectué après dépôt afin d'obtenir une surface supérieure de couche 23 plane. La surface supérieure de la couche 23 est située au-dessus du sommet de la couche 31 tridimensionnelle. La surface supérieure de la couche 23 est de préférence séparée du sommet de la couche 31 tridimensionnelle d'au moins quelques dizaines de nanomètres, par exemple au moins 20 nm. La couche métallique 23 peut correspondre à un troisième niveau de métal.

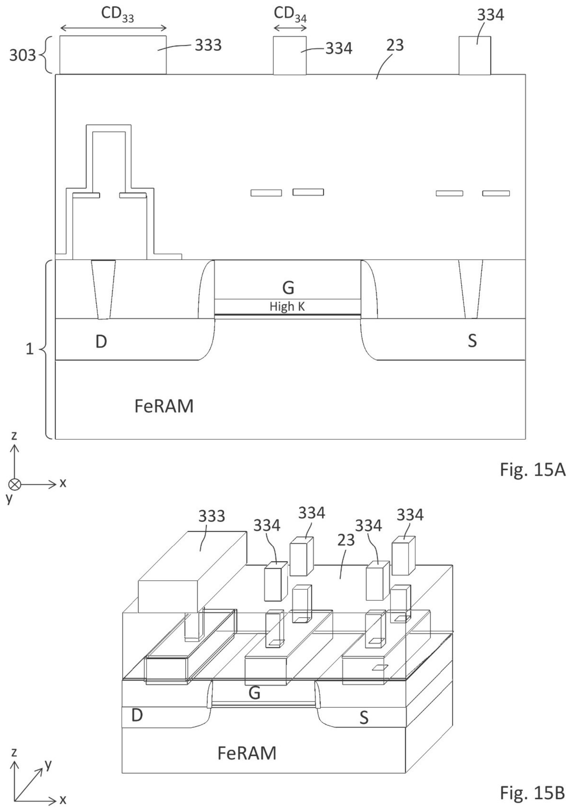

Comme illustré aux figures 15A, 15B, un troisième masque 303 comprenant par exemple des motifs de via 334 et un motif d'électrode 333 est formé sur la troisième couche métallique 23. Les motifs de via 334 sont alignés à l'aplomb des vias 222. Ils présentent de préférence une dimension CD₃₄ inférieure à la dimension CD₁ des portions 32a, 32c. Le motif d'électrode 333 est aligné à l'aplomb de la couche 31 restante. Il présente typiquement une dimension CD₃₃ supérieure à la dimension CD₁ de la portion 32b.

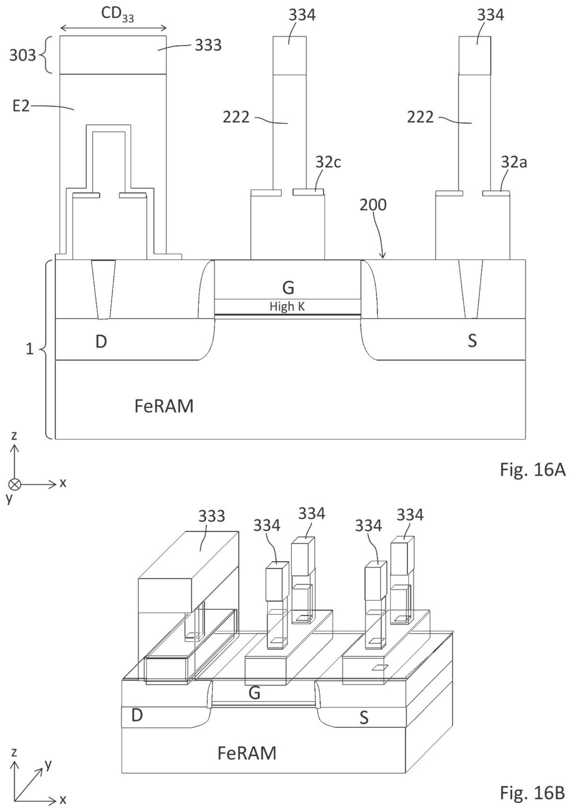

Comme illustré aux figures 16A, 16B, la troisième couche métallique 23 est ensuite structurée par gravure au travers du masque 303. La gravure est effectuée jusqu'à la surface 200, le long des premier, deuxième et troisième niveaux de métal. Une deuxième électrode E2 surmontant la couche 31 tridimensionnelle est ainsi formée. La surface développée de l'interface entre la couche 31 tridimensionnelle et la deuxième électrode E2 est significativement augmentée en comparaison d'une architecture d'élément mémoire basée sur une couche diélectrique ou ferroélectrique 2D intercalée entre les électrodes (la comparaison étant faite pour une empreinte d'élément mémoire équivalente sur la puce microélectronique). Les vias 222 et les lignes 212 sont également reformés lors de cette gravure. Les vias 222 s'étendent maintenant le long des deuxième et troisième niveaux de métal.

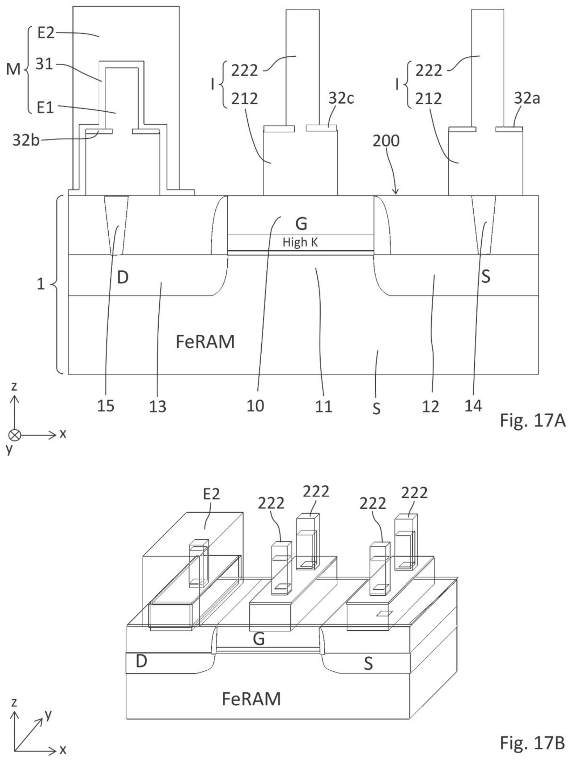

Comme illustré aux figures 17A, 17B, après retrait du masque 303, un élément mémoire M comprenant la première électrode E1, la couche 31 et la deuxième électrode E2 est obtenu. Cet élément mémoire M est connecté au drain 13 du transistor 1. L'élément mémoire M est avantageusement intégré dans les niveaux d'interconnexions BEOL. Il s'étend ici le long des premier, deuxième et troisième niveaux de métal. Simultanément, des interconnexions I (222, 212), connectées respectivement à la source 12 et à la grille 10 du transistor 1, sont également obtenues.

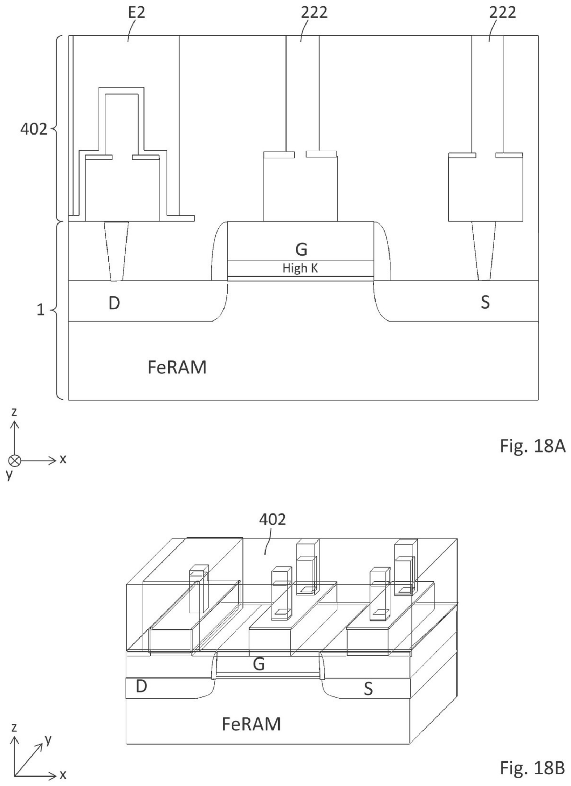

Comme illustré aux figures 18A, 18B, les interconnexions I et l'élément mémoire M sont ensuite classiquement intégrés dans une matrice diélectrique par dépôt et planarisation d'une couche diélectrique 402, typiquement à base de SiO₂.

Une cellule mémoire, par exemple de type 1T1R, comprenant un transistor 1 de sélection et un élément mémoire M tridimensionnel intégré dans les niveaux d'interconnexions, est avantageusement réalisée.

Comme illustré aux figures 19A, 19B, une quatrième couche métallique, correspondant par exemple à un quatrième niveau de métal, peut ensuite être déposée sur la couche 402, l'électrode E2 et les vias 222 affleurant. Cette quatrième couche métallique est typiquement structurée sous forme de lignes 241 connectant l'électrode E2 et les vias 222. Ce quatrième niveau de métal peut être ensuite intégré dans une matrice diélectrique par dépôt et planarisation d'une couche diélectrique 403, typiquement à base de SiO₂.

L'invention n'est pas limitée aux modes de réalisations précédemment décrits. En particulier, il est envisageable de structurer les interconnexions et l'élément mémoire différemment. Les dimensions des vias, des lignes et des électrodes peuvent varier, selon les spécifications requises en performance pour les cellules mémoires et/ou en fonction de l'application choisie.

## Revendications

1. Dispositif mémoire non volatile comprenant en empilement suivant une direction z :
• un élément de sélection (1) comprenant au moins deux électrodes (10, 12, 13),
• une interconnexion (I) connectant l'une desdites au moins deux électrodes,
• un élément mémoire (M) comprenant :
∘ une première électrode (E1) connectant l'autre desdites au moins deux électrodes de l'élément de sélection, la première électrode (E1) comprenant :
- une ligne métallique (211) à base d'un premier métal et,
- un via métallique (221) à base d'un deuxième métal,
- une portion (32b) d'une couche d'arrêt de gravure (30) intercalée entre le via (221) et la ligne (211), ladite portion (32b) comprenant au moins une ouverture de via (320) de sorte que le via (221) et la ligne (211) sont connectés au travers de ladite au moins une ouverture de via (320),
∘ une couche (31) à base d'un matériau diélectrique ou ferroélectrique couvrant la ligne (211) et le via (221),
∘ une deuxième électrode (E2) surmontant la couche (31) à base du matériau diélectrique ou ferroélectrique.

2. Dispositif selon la revendication précédente, dans lequel la couche (31) à base d'un matériau diélectrique ou ferroélectrique présente au moins une portion (311h, 312h) dite horizontale, s'étendant perpendiculairement à la direction z, séparant les première et deuxième électrodes (E1, E2), et au moins une portion (311v, 312v) dite verticale, s'étendant parallèlement à la direction z, séparant les première et deuxième électrodes (E1, E2).

3. Dispositif selon la revendication précédente, dans lequel l'au moins une portion (311h, 312h) horizontale comprend une première portion (311h) horizontale sur le via métallique (221) de la première électrode (E1) et une deuxième portion (312h) horizontale sur la portion (32b) de la couche d'arrêt de gravure (30) de l'élément mémoire (M), et dans lequel l'au moins une portion (311v, 312v) verticale comprend une première portion (311v) verticale sur au moins un flanc du via métallique (221) de la première électrode (E1) et une deuxième portion (312v) verticale sur au moins un flanc de la ligne métallique (211) de la première électrode (E1).

4. Dispositif selon l'une quelconque des revendications précédentes, dans lequel le via métallique (221) de la première électrode (E1) de l'élément mémoire (M) présente une dimension critique CDᵥᵢₐ₂₂₁, prise selon un axe x perpendiculaire à la direction z, supérieure ou égale à une dimension CDₒₚₑₙ de l'au moins une ouverture de via (320) prise selon l'axe x.

5. Dispositif selon l'une quelconque des revendications précédentes, dans lequel la couche (31) à base d'un matériau diélectrique ou ferroélectrique est à base d'un matériau ferroélectrique pris parmi : HfₓZr₁₋ₓO₂, HfO₂ dopé par l'un au moins parmi les éléments dopants suivants : Si, N, Gd, Y, Sc, Ge, avec une concentration en éléments dopants comprise entre 0,5% et 10%at.

6. Dispositif selon l'une quelconque des revendications 1 à 4, dans lequel la couche (31) à base d'un matériau diélectrique ou ferroélectrique est à base d'un matériau diélectrique pris parmi : HfOₓ, TaOₓ avec 1,8 ≤ x ≤ 2.

7. Dispositif selon l'une quelconque des revendications précédentes, dans lequel l'élément de sélection est pris parmi : un transistor à effet de champ ou un transistor ferroélectrique à effet de champ, une diode, un sélecteur.

8. Dispositif selon l'une quelconque des revendications précédentes, comprenant en empilement suivant une direction z :
• un transistor (1) comprenant une grille (10) surmontant un canal (11), une source (12) et un drain (13) de part et d'autre du canal (11),
• une interconnexion (I) connectant la source (12), comprenant :
∘ une ligne métallique (212) à base du premier métal, et,
∘ un via métallique (222) à base du deuxième métal, connecté à ladite au moins une ligne métallique (212),
∘ une première portion (32a) de couche d'arrêt de gravure (30) intercalée entre le via (222) et la ligne (212), ladite première portion (32a) comprenant au moins une ouverture de via (320) de sorte que le via (222) et la ligne (212) sont connectés au travers de ladite au moins une ouverture de via (320),
• un élément mémoire (M) connectant le drain (13), comprenant :
∘ une première électrode (E1) connectée au drain (13) comprenant :
- une ligne métallique (211) à base du premier métal et,
- un via métallique (221) à base du deuxième métal,
- une deuxième portion (32b) de la couche d'arrêt de gravure (30) intercalée entre le via (221) et la ligne (211), ladite deuxième portion (32b) comprenant au moins une ouverture de via (320) de sorte que le via (221) et la ligne (211) sont connectés au travers de ladite au moins une ouverture de via (320),
∘ une couche (31) à base d'un matériau diélectrique ou ferroélectrique couvrant la ligne (211) et le via (221),
∘ une deuxième électrode (E2) surmontant la couche (31) à base du matériau diélectrique ou ferroélectrique,
• une interconnexion (I) connectant la grille (10), comprenant :
∘ une ligne métallique (212) à base du premier métal, et,
∘ un via métallique (222) à base du deuxième métal,
∘ une troisième portion (32c) de la couche d'arrêt de gravure (30) intercalée entre le via (222) et la ligne (212), ladite troisième portion (32c) comprenant au moins une ouverture de via (320) de sorte que le via (222) et la ligne (212) sont connectés au travers de ladite au moins une ouverture de via (320).

9. Procédé de fabrication d'un dispositif mémoire non volatile selon l'une quelconque des revendications précédentes, ledit procédé comprenant :
• une fourniture d'un élément de sélection (1) comprenant au moins deux électrodes présentant chacune une face (140, 150, 100) exposée au niveau d'une surface supérieure (200),
• une formation d'une première couche métallique (21) sur les faces (140, 150, 100) exposées de la surface supérieure (200),
• une formation, sur la première couche métallique (21), d'une couche d'arrêt de gravure (30),
• une structuration de la couche d'arrêt de gravure (30), par l'intermédiaire d'un premier masque (301), de façon à exposer des parties de la première couche métallique (21) et à conserver des parties de la couche d'arrêt de gravure (30) sous forme d'une portion (32b) surmontant l'une desdites au moins deux électrodes de l'élément de sélection (1), ladite portion (32b) comprenant une ouverture de via (320) débouchant sur la première couche métallique (21) sous-jacente,
• une formation d'une deuxième couche métallique (22) sur la portion (32b) de la couche d'arrêt de gravure (30) et sur les parties exposées de la première couche métallique (21),
• une formation, sur la deuxième couche métallique (22), d'un deuxième masque (302) définissant au moins un via (221) à l'aplomb de l'ouverture de via (320) de la portion (32b) de la couche d'arrêt de gravure (30), et au moins en partie une interconnexion (I) à l'aplomb de l'autre desdites au moins deux électrodes de l'élément de sélection (1),
• une gravure de la deuxième couche métallique (22), ladite gravure étant configurée pour former, en s'arrêtant sur la portion (32b) de la couche d'arrêt de gravure (30), un via (221) à l'aplomb de l'ouverture de via (320) de ladite portion (32b), et au moins en partie l'interconnexion (I),
• une gravure de la première couche métallique (21) de part et d'autre de la portion (32b) de la couche d'arrêt de gravure (30), ladite gravure étant configurée pour former l'interconnexion (I) et pour former, en s'arrêtant sur la surface supérieure (200), une ligne métallique (211) sous ladite portion (32b), le via (221) et la ligne métallique (211) formant une première électrode (E1) d'un élément mémoire (M) du dispositif,
• une formation d'une couche (31) à base d'un matériau diélectrique ou ferroélectrique sur la première électrode (E1),
• une formation d'une troisième couche métallique (23) sur la couche à base d'un matériau diélectrique ou ferroélectrique,
• une formation, sur la troisième couche métallique (23), d'un troisième masque (303) définissant au moins un via (222) à l'aplomb de l'interconnexion (I), et définissant une deuxième électrode (E2) de l'élément mémoire (M) à l'aplomb de la couche (31) à base d'un matériau diélectrique ou ferroélectrique,
• une gravure de la troisième couche métallique (23) ladite gravure étant configurée pour former ou reformer l'interconnexion (I), ladite gravure étant configurée pour former, en s'arrêtant sur la surface supérieure (200) ou sur la couche (31) à base d'un matériau diélectrique ou ferroélectrique, la deuxième électrode (E2) de l'élément mémoire (M).

10. Procédé selon la revendication précédente, dans lequel la gravure de la deuxième couche métallique (22) et la gravure de la première couche métallique (21) sont enchainées selon une seule et même séquence de gravures.

11. Procédé selon l'une quelconque des revendications 9 à 10, dans lequel la formation de la couche (31) à base du matériau diélectrique ou ferroélectrique comprend :
• Un dépôt conforme de la couche (31) à base du matériau diélectrique ou ferroélectrique sur la première électrode (E1) et sur l'interconnexion (I), puis
• Une structuration par lithographie et gravure de façon à retirer des parties de la couche (31) à base du matériau diélectrique ou ferroélectrique déposées sur l'interconnexion (I), et à conserver une partie de la couche (31) à base du matériau diélectrique ou ferroélectrique déposée sur la première électrode (E1).

12. Procédé selon l'une quelconque des revendications 9 à 11, comprenant en outre, après formation de la couche (31) à base du matériau diélectrique ou ferroélectrique, un dépôt d'une couche barrière à la diffusion, par exemple à base de titane.

13. Procédé selon l'une quelconque des revendications 9 à 12, dans lequel la couche d'arrêt de gravure (30) est à base d'un matériau pris parmi : SiO₂, TiO₂, HfO₂, HfN, ZrN, SiN, SiCN.

14. Procédé selon l'une quelconque des revendications 9 à 13, comprenant :
• une fourniture d'un transistor (1) comprenant une grille (10) surmontant un canal (11), une source (12) et un drain (13) de part et d'autre du canal (11), et des vias (14, 15) connectant la source (12) et le drain (13), lesdits vias (14, 15) et ladite grille (10) présentant chacun une face (140, 150, 100) exposée au niveau d'une surface supérieure (200),
• une formation d'une première couche métallique (21) sur les faces (140, 150, 100) exposées de la surface supérieure (200),
• une formation, sur la première couche métallique (21), d'une couche d'arrêt de gravure (30) présentant une sélectivité à la gravure S_{21:30} supérieure ou égale à 5:1 vis-à-vis de la première couche métallique (21),
• une structuration de la couche d'arrêt de gravure (30), par l'intermédiaire d'un premier masque (301), de façon à exposer des parties de la première couche métallique (21) et à conserver des parties de la couche d'arrêt de gravure (30) sous forme de première et deuxième portions (32a, 32b) surmontant chacun des vias (14, 15) connectant la source (12) et le drain (13), et d'une troisième portion (32c) surmontant la grille (10) du transistor (1), lesdites première, deuxième et troisième portions (32a, 32b, 32c) comprenant chacune une ouverture de via (320) débouchant sur la première couche métallique (21) sous-jacente,
• une formation d'une deuxième couche métallique (22) sur les première, deuxième et troisième portions (32a, 32b, 32c) de la couche d'arrêt de gravure (30) et sur les parties exposées de la première couche métallique (21),
• une formation, sur la deuxième couche métallique (22), d'un deuxième masque (302) définissant des vias (222, 221) à l'aplomb des ouvertures de via (320) des première, deuxième et troisième portions (32a, 32b, 32c) de la couche d'arrêt de gravure (30),
• une gravure de la deuxième couche métallique (22), ladite gravure étant configurée pour former, en s'arrêtant sur les première, deuxième et troisième portions (32a, 32b, 32c) de la couche d'arrêt de gravure (30), respectivement un premier via (222) à l'aplomb de l'ouverture de via (320) de la première portion (32a), un deuxième via (221) à l'aplomb de l'ouverture de via (320) de la deuxième portion (32b), un troisième via (222) à l'aplomb de l'ouverture de via (320) de la troisième portion (32c),
• une gravure de la première couche métallique (21) de part et d'autre des première, deuxième et troisième portions (32a, 32b, 32c) de la couche d'arrêt de gravure (30), ladite gravure étant configurée pour former, en s'arrêtant sur la surface supérieure (200), une première ligne métallique (212) sous la première portion (32a), une deuxième ligne métallique (211) sous la deuxième portion (32b), une troisième ligne métallique (212) sous la troisième portion (32c), le deuxième via (221) et la deuxième ligne métallique (211) formant une première électrode (E1) d'un élément mémoire (M) du dispositif,
• une formation d'une couche (31) à base d'un matériau diélectrique ou ferroélectrique sur la première électrode (E1),
• une formation d'une troisième couche métallique (23) sur la couche à base d'un matériau diélectrique ou ferroélectrique et sur les deuxième et troisième vias,
• une formation, sur la troisième couche métallique (23), d'un troisième masque (303) définissant des vias (222) à l'aplomb des ouvertures de via (320) des première et troisième portions (32a, 32c) de la couche d'arrêt de gravure, et définissant une deuxième électrode (E2) de l'élément mémoire (M) à l'aplomb de la couche (31) à base d'un matériau diélectrique ou ferroélectrique,
• une gravure de la troisième couche métallique (23) ladite gravure étant configurée pour former ou reformer, en s'arrêtant sur les première et troisième portions (32a, 32c) de la couche d'arrêt de gravure (30), respectivement le premier via (222) à l'aplomb de l'ouverture de via (320) de la première portion (32a), le troisième via (222) à l'aplomb de l'ouverture de via (320) de la troisième portion (32c), ladite gravure étant configurée pour former, en s'arrêtant sur la surface supérieure (200) ou sur la couche (31) à base d'un matériau diélectrique ou ferroélectrique, la deuxième électrode (E2) de l'élément mémoire (M).
